# EUROPÄISCHE PATENTANMELDUNG

(11) **EP 0 859 543 A2**
(43) Veröffentlichungstag der Anmeldung: **19.08.1998**
(21) Anmeldenummer: 98102459.9
(22) Anmeldetag: 12.02.1998
(51) Int. Cl.: H05K 13/04

(54) **Verfahren zur Zuführung von Bauelementen zu einem Bestückungsautomaten sowie Zuführeinheit und Bestückungsautomat zur Durchführung des Verfahrens**

(30) Priorität: 18.02.1997 CH 361/97
(71) Anmelder: Zevatech Trading AG, 2545 Selzach (CH)
(72) Erfinder: Gfeller, Martin, 3314 Schalunen (CH); Christen, Otto, 4702 Oensingen (CH); Grunder, Emil, 4614 Hägendorf (CH)
(74) Vertreter: Zinnecker, Armin, Dipl.-Ing.

(57) **Zusammenfassung**

Bei einem Verfahren zur Zuführung von Bauelementen, die in einem mit einer periodischen Abfolge von einzelnen Taschen versehenen Band (23) untergebracht sind, mittels einer Zuführeinheit (1) zu einem Bestückungsautomaten, bei welchem Verfahren das auf einer Spule (21) aufgewickelte Band (23) in der Zuführeinheit (1) von der Spule (21) abgewickelt und die in den Taschen befindlichen Bauelemente nacheinander zu einer Entnahmestelle (13) transportiert werden, wo sie von dem Bestückungsautomaten aus der jeweiligen Tasche des Bandes entnommen werden können, wird eine einfache Bauteileversorgung ohne Bestückungsleistungsverlust dadurch erreicht, dass vor dem Ende eines von einer ersten Spule in der Zuführeinheit (1) abgewickelten ersten Bandes bei laufendem Bestückungsvorgang das Bandende des ersten Bandes und der Bandanfang eines auf einer zweiten Spule aufgewickelten zweiten Bandes mittels eines Spleisses miteinander verbunden werden, dass in der Zuführeinheit (1) die erste Spule gegen die zweite Spule ausgetauscht wird, und dass nach dem Auslaufen des ersten Bandes selbsttätig die in den Taschen des zweiten Bandes befindlichen Bauelemente von der Zuführeinheit (1) nacheinander zu der Entnahmestelle (13) transportiert werden.

## Beschreibung

### TECHNISCHES GEBIET

Die vorliegende Erfindung bezieht sich auf das Gebiet der automatisierten Bestückung von elektronischen Schaltungen mit elektronischen Bauelementen. Sie betrifft ein Verfahren zur Zuführung von Bauelementen, die in einem mit einer periodischen Abfolge von einzelnen Taschen versehenen Band untergebracht sind, mittels einer Zuführeinheit zu einem Bestückungsautomaten, bei welchem Verfahren das auf einer Spule aufgewickelte Band in der Zuführeinheit von der Spule abgewickelt und die in den Taschen befindlichen Bauelemente nacheinander zu einer Entnahmestelle transportiert werden, wo sie von dem Bestückungsautomaten aus der jeweiligen Tasche des Bandes entnommen werden können.

Die Erfindung betrifft weiterhin eine Zuführeinheit zur Durchführung eines solchen Verfahrens, in welcher Zuführeinheit das mit den Bauelementen gefüllte Band mittels eines durch eine Steuereinheit gesteuerten Antriebs schrittweise an einer Entnahmestelle vorbeibewegt wird, wobei die Steuereinheit über Verbindungsmittel mit einer Zentraleinheit des Bestückungsautomaten Daten austauscht.

Die Erfindung betrifft auch einen Bestückungsautomaten zur Durchführung eines solchen Verfahrens, umfassend eine Zentraleinheit zur Steuerung des Bestückungsvorgangs.

### STAND DER TECHNIK

Die automatische Bestückung von elektronischen Schaltungen (PCBs oder dgl.) mittels Bestückungsautomaten ist seit langem bekannt und wird insbesondere dort eingesetzt, wo komplizierte und umfangreiche Schaltungen auch in grosser Stückzahl schnell, effizient und fehlerfrei mit einer grösseren Anzahl von Bauelementen bestückt werden müssen. Die Bauelemente liegen dabei nach Typen getrennt auf einzelnen Bändern vor, die auf Spulen aufgerollt sind und mittels entsprechender Zuführeinheiten (Feeder) schrittweise an einer Entnahmestelle (Pick-up position) vorbeigeführt werden, wo sie von einem Handhabungsautomaten entnommen und an dem zugewiesenen Platz in der Schaltung abgesetzt werden. Die Bauelemente sind dabei auf dem Band einzeln in periodisch hintereinander angeordneten Taschen untergebracht und in der Regel durch ein darüberliegendes Deckband gegen Herausfallen oder Beschädigung geschützt. Derartige automatische Bestückungsvorrichtungen sind beispielsweise aus den US-Patenten 4,610,083, 4,653,664, 5,191,693, 5,289,625 und 5,515,600 oder den Japanischen Patentanmeldungen JP-A-05145283, JP-A-02135800, JP-A-03133763 und JP-A-03008655 bekannt.

Wenn beim Betrieb eines solchen Bestückungsautomaten im fortlaufenden Bestückungsprozess mehr Bauelemente einer Sorte benötigt werden, als auf der zugehörigen Bandspule vorgehalten werden, muss beim Erreichen des Bandendes eine neue Spule mit einem neuen Band in die Zuführeinheit eingesetzt werden. Dazu ist es notwendig, bei sich abzeichnendem Bandende das Bedienpersonal zu informieren, damit entsprechende Massnahmen eingeleitet werden können. Für dieses Problem sind bereits verschiedene Lösungsvorschläge gemacht worden. So wird in der JP-A-03008655, der JP-A-05145283, der US-A-4,653,664 oder der US-A-5,191,693 vorgeschlagen, auf dem Band, insbesondere dem Deckband, verschiedenartige Markierungen anzubringen, die mit einem vor oder hinter der Entnahmestelle angeordneten Sensor detektiert werden und die vor dem Bandende warnen und gleichzeitig eine Abschätzung bzw. Berechnung der noch verbleibenden Nutzungszeit des eingesetzten Bandes ermöglichen. Andere Vorschläge wie die aus der JP-A-02135800 und JP-A-03133763 verwenden als Markierung eine codierte Abfolge von leeren und vollen Taschen innerhalb des Bandes, die am Ausgang des Sensors einem bestimmten Bitmuster entspricht, welches in der Steuerung der Vorrichtung verarbeitet werden kann.

Obwohl sich das Bedienpersonal aufgrund der Vorwarnung bzw. der Voranzeige des Bestückungsautomaten rechtzeitig auf einen bevorstehenden Bandwechsel vorbereiten kann, ist mit dem Bandwechsel selbst ein Unterbruch im Bestückungsvorgang verbunden. Die zuführeinheit wird aus ihrem Steckplatz am Bestückungsautomaten herausgezogen, die leere Spule wird gegen eine volle Spule mit einem neuen Band umgetauscht, der Bandanfang des neuen Bandes wird eingefädelt und die Zuführeinheit wird wieder in ihren Steckplatz am Bestückungsautomaten eingesteckt. Gleichzeitig müssen die charakteristischen Daten (Bandlänge, Bandbreite, Pitch, Anzahl der Taschen bzw. Bauelemente, Typ der Bauelemente) des neuen Bandes in den Bestückungsautomaten eingegeben und aktiviert werden, damit der Bestückungsprozess in der gewohnten Weise fortgeführt werden kann. Hierdurch kommt es zu Stillstandszeiten bei der Bestückung, welche die Bestückungsleistung der gesamten Vorrichtung begrenzen bzw. herabsetzen.

### DARSTELLUNG DER ERFINDUNG

Es ist daher Aufgabe der Erfindung, ein Verfahren zur Zuführung von Bauelementen anzugeben, bei welchem ein Bandwechsel ohne Leistungseinbusse durchgeführt werden kann, sowie eine dafür geeignete Zuführeinheit und einen Bestückungsautomaten anzugeben.

Die Aufgabe wird bei einem Verfahren der eingangs genannten Art dadurch gelöst, dass vor dem Ende eines von einer ersten Spule in der Zuführeinheit abgewickelten ersten Bandes bei laufendem Bestückungsvorgang das Bandende des ersten Bandes und der Bandanfang eines auf einer zweiten Spule aufgewickelten zweiten Bandes mittels eines Spleisses miteinander verbunden werden, dass in der Zuführeinheit die erste Spule gegen die zweite Spule ausgetauscht wird, und dass nach dem Auslaufen des ersten Bandes selbsttätig die in den Taschen des zweiten Bandes befindlichen Bauelemente von der Zuführeinheit nacheinander zu der Entnahmestelle transportiert werden. Durch das Anspleissen des nächsten Bandes an das Ende des gerade benutzten Bandes, welches Anspleissen ohne Unterbruch des Bestückungsvorganges und asynchron dazu ausserhalb der Zuführeinheit durchgeführt werden kann, wird ein automatischer und reibungsloser Uebergang zwischen den Bändern ohne Leistungseinbusse gewährleistet.

Eine erste bevorzugte Ausführungsform des erfindungsgemässen Verfahrens zeichnet sich dadurch aus, dass in der Zuführeinheit der Durchlauf des Spleisses vor der Entnahmestelle detektiert wird, und dass auf die Detektion des Spleisses hin charakteristische Daten des zweiten Bandes und der darin enthaltenen Bauelemente selbsttätig für die Steuerung des Bestückungsautomaten bereitgestellt werden. Hierdurch wird sichergestellt, dass die Datenübernahme bei Beginn des neuen Bandes ohne Eingriff des Bedienpersonals synchron vonstatten geht.

Eine Weiterbildung dieser Ausführungsform ist dadurch gekennzeichnet, dass im Zusammenhang mit dem Spleissen des ersten und zweiten Bandes die charakteristischen Daten des zweiten Bandes bzw. der darin enthaltenen Bauelemente zunächst in einen Datenspeicher eingelesen werden, und dass die Daten nach der Detektion des Spleisses aus dem Datenspeicher ausgelesen und an eine Zentraleinheit zur Steuerung des Bestückungsautomaten weitergegeben werden. Die Eingabe der Daten des neuen Bandes kann auf diese Weise asynchron erfolgen, ohne dass der Bestückungsprozess in irgendeiner Weise gestört wird.

Die Sicherheit gegen eine fehlerhafte Bestückung wird gemäss einer weiteren bevorzugten Ausführungsform des Verfahrens nach der Erfindung dadurch erhöht, dass nach dem Einlesen der charakteristischen Daten des zweiten Bandes die charakteristischen Daten der beiden Bänder und der Bauelemente in beiden Bändern im Bestückungsautomaten zunächst selbsttätig miteinander verglichen werden, und der Bestückungsprozess mit Bauelementen des zweiten Bandes nur dann weitergeführt wird, wenn zwischen den verglichenen charakteristischen Daten eine vorgegebene Uebereinstimmung festgestellt wird.

Eine weitere bevorzugte Ausführungsform des erfindungsgemässen Verfahrens zeichnet sich dadurch aus, dass zur Anzeige des Spleisses an den gespleissten Bändern Markierungen vorgesehen sind, dass zur Detektion des Spleisses die Markierungen detektiert werden, dass als Markierungen optische Markierungen verwendet werden, welche optisch detektiert werden, dass als optische Markierung eine Aussparung verwendet wird, und dass die Aussparung direkt am Spleiss angeordnet ist. Eine solche Aussparung lässt sich beim Spleissen durch einen Schneid- oder Stanzvorgang besonders einfach am Bandübergang anbringen und ist einfach und sicher zu detektieren.

Die erfindungsgemässe Zuführeinheit zeichnet sich dadurch aus, dass in Laufrichtung des Bandes vor der Entnahmestelle ein Spleiss-Sensor für die Detektion eines Spleisses angeordnet ist.

Eine bevorzugte Ausführungsform dieser Zuführeinheit ist dadurch gekennzeichnet, dass zusätzlich zu dem Spleiss-Sensor ein Bandabschnitts-Sensor zur Detektion von Bandabschnitten vorgesehen ist, und dass als Bandabschnitts-Sensor ein Leertaschen-Sensor zur Detektion von Leertaschen eingesetzt wird. Durch eine (an sich bekannte) codierte Abfolge von Leertaschen und vollen Taschen kann das jeweilige Band auf sehr einfache in einzelne Abschnitte unterteilt werden, in denen beispielsweise Bauelemente aus demselben Herstellungs-Batch untergebracht sind. Stellt der Bestückungsautomat aufgrund der Abschnittsdetektion fest, dass für eine ordnungsgemässe Bestückung auf dem alten Band nicht mehr genügend Bauelemente vorhanden sind, kann die Zuführungseinheit direkt an den durch den Spleiss gekennzeichneten Anfang des nächsten Bandes vorrücken, ohne dass unnötig Zeit verschenkt wird.

Der erfindungsgemässe Bestückungsautomat ist dadurch gekennzeichnet, dass ein Datenspeicher zur Speicherung der charakteristischen Daten eines neuen Bandes vorgesehen ist, und dass der Datenspeicher mit der Zentraleinheit verbunden ist.

Weitere Ausführungsformen der Erfindung ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in einer perspektivischen Seitenansicht ein bevorzugtes Ausführungsbeispiel für eine Zuführeinheit nach der Erfindung;
- Fig. 2: in der Draufsicht zwei beispielhafte Spleissverbindungen, wie sie bei dem Verfahren nach der Erfindung vorzugsweise Anwendung finden;
- Fig. 3: die geometrische Anordnung eines Spleiss-Sensors und eines Leertaschen-Sensors in einem kombinierten Bandsensor für eine Spleissverbindung nach Fig. 3;
- Fig. 4: das Blockschaltbild der Steuerung von Zuführeinheit und Bestückungsautomat gemäss einem bevorzugten Ausführungsbeispiel der Erfindung; und
- Fig. 5: schematisch die Zuordnung von Bandsensor und Entnahmestelle relativ zur Einteilung (Pitch) des Bandes bei der Erfindung.

### WEGE ZUR AUSFÜHRUNG DER ERFINDUNG

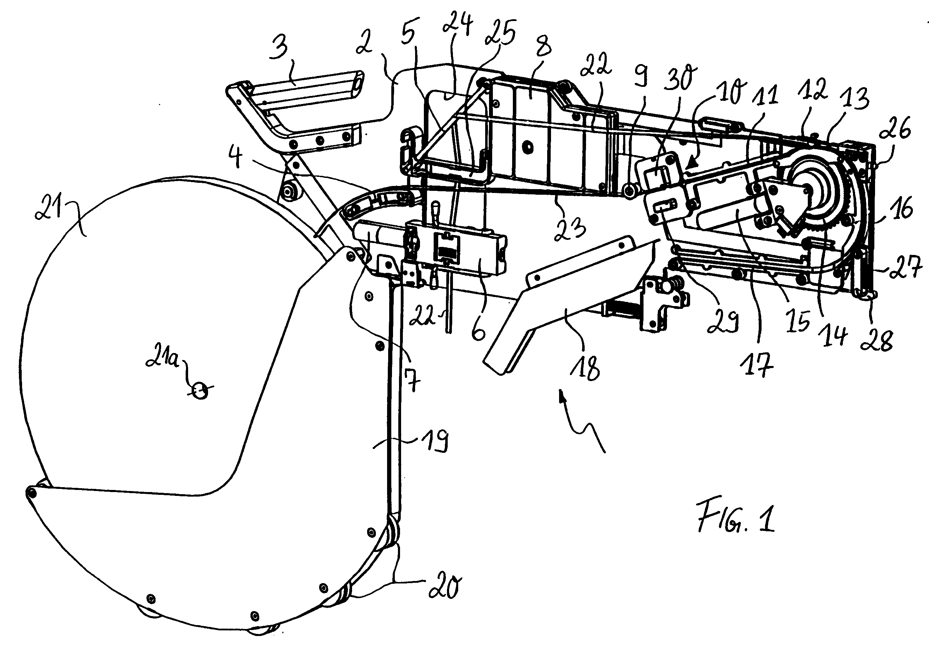

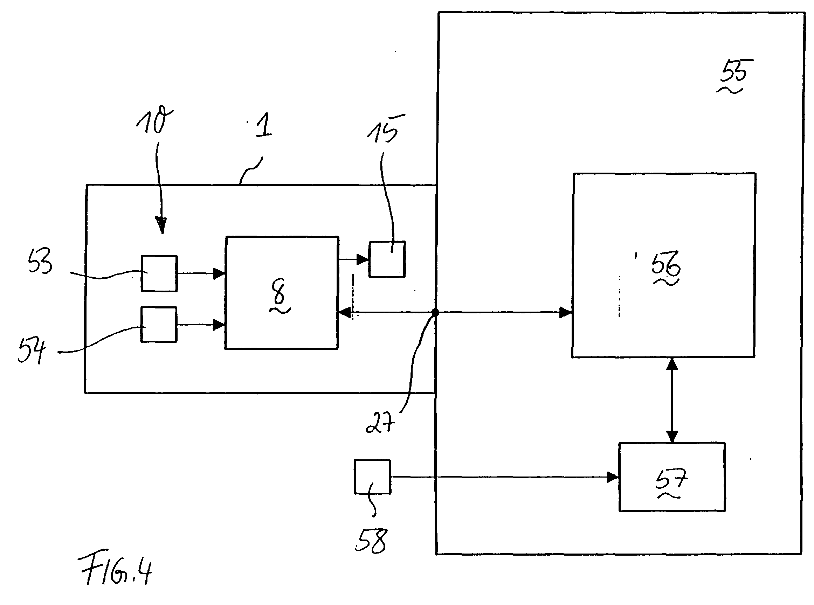

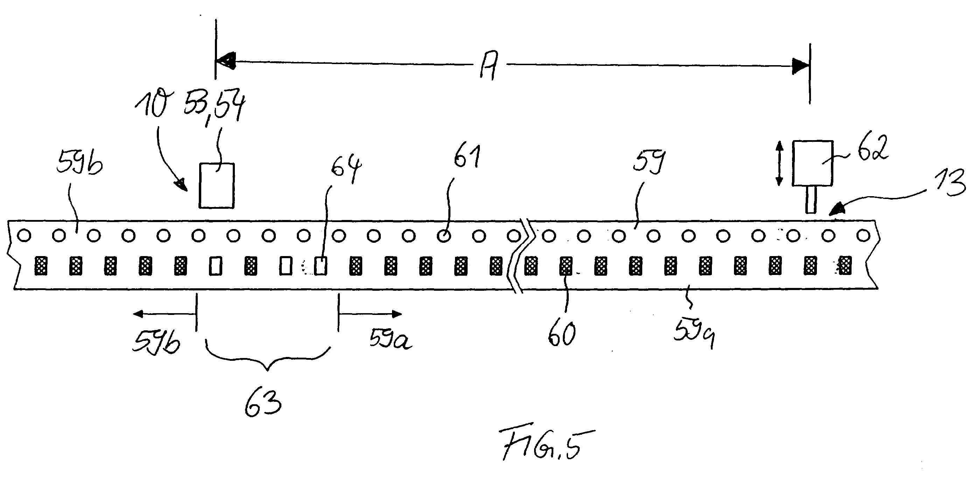

In der Fig. 1 ist in perspektivischer Seitenansicht ein bevorzugtes Ausführungsbeispiel einer erfindungsgemässen Zuführeinheit wiedergegeben. Die Zuführeinheit 1 ist auf einer Grundplatte 2 aus Metall aufgebaut, an welche eine Spulenaufnahme 19 angeschraubt ist. Die Spulenaufnahme 19 ist nach oben hin offen. In sie kann eine Spule 21 mit dem aufgerollten, die Bauelemente enthaltenden Band eingesetzt werden und sich auf mehreren am unteren Rand der Spulenaufnahme 19 angeordneten Laufrollen 20 frei drehen. Der Achse 21a der Spule 21 kommt dabei keine Funktion zu. Durch diese Ausbildung der Spulenaufnahme 19 ist es möglich, bei mehreren eng nebeneinander am Bestückungsautomaten angeordneten Zuführeinheiten die Spule 21 leicht zum Zwecke des Spleissens herauszunehmen und wieder einzusetzen, ohne dass die Zuführeinheit 1 selbst abgenommen werden muss. Das Band 23 wird aus der Spule 21 heraus durch den zentralen Teil der Zuführeinheit 1 nach vorne geführt, wo an einer Entnahmestelle 13 eine (nicht dargestellte) Entnahmevorrichtung (62 in Fig. 5) eines (nicht dargestellten) Bestückungsautomaten (55 in Fig. 4) die Bauteile entnimmt.

Unterhalb der Entnahmestelle 13 ist ein von einem Antriebsmotor 15 angetriebenes Transportrad 14 angeordnet. Das Transportrad 14 ist als Zahnrad ausgebildet und greift mit seinen Zähnen in entsprechende Perforationen im Band 23 ein. Der Transport des Bandes 23 durch das Transportrad 14 erfolgt schrittweise und wird von einer elektronischen Steuereinheit 8 gesteuert, die in der Zuführeinheit 1 untergebracht ist. Die Führung des Bandes 23 aus der Spule 21 heraus zum Transportrad 14 hin erfolgt über ein erstes, leicht gekrümmtes Führungselement 4, eine Umlenkrolle 9 und einen ersten Führungskanal 11. Zwischen der Umlenkrolle 9 und dem Eingang des ersten Führungskanals ist ein (optischer) Bandsensor 10 vorgesehen, dessen Funktion weiter unten näher erläutert werden wird.

Das Band 23 besteht in bekannter Weise aus einem mit Taschen für die Bauelemente versehenen Trägerband, welches durch ein aufgeklebtes Deckband verschlossen ist. Vor der Entnahmestelle 13 wird mittels einer Abziehvorrichtung 12, wie sie beispielhaft in der US-A-5,213,653 beschrieben ist, das Deckband 22 entgegen der Laufrichtung des Bandes 23 nach hinten abgezogen. Das Trägerband wird hinter der Entnahmestelle 13 durch einen zweiten, gebogenen Führungskanal 16 um das Transportrad 14 herum und durch einen dritten, geraden Führungskanal 17 nach hinten geführt und durch ein weiteres Führungselement 18 nach unten aus der Zuführeinheit 1 herausgelenkt.

Das abgezogene Deckband 22 läuft ohne weitere Führung an der Steuereinheit 8 vorbei zu einer Umlenkwelle 5 und wird dort nach unten umgelenkt und zugleich in der Bandachse um 90° gedreht, so dass die Fläche des Deckbandes 22 hinter der Umlenkwelle 5 in etwa parallel zur Grundplatte 2 orientiert ist. Die kombinierte Umlenkung und Drehung des Deckbandes wird dadurch erreicht, dass die Umlenkwelle 5 in der Ebene des Bandes 23 bzw. des Deckbandes 22 liegt, und dass die Umlenkwelle 5 mit der Laufrichtung des abgezogenen Deckbandes 22 einen Winkel von ungefähr 45° einschliesst.

Die Umlenkwelle 5 ist etwas oberhalb der Grundplatte 2 angeordnet. Damit das umgelenkte Deckband 22 leicht um die Umlenkwelle 5 gelegt und unterhalb der Umlenkwelle 5 sicher an dem dort vorbeilaufenden Band 23 vorbeigeführt werden kann, ist unter der Umlenkwelle 5 und im Bereich zwischen der Umlenkwelle 5 und der Antriebseinheit 6 in der Grundplatte 2 eine Aussparung 24 vorgesehen. Das Deckband 22 wird in seiner um 90° gedrehten Orientierung in der Aussparung 24 an dem Band 23 vorbeigeführt. Zur Führung des Deckbandes 22 in der Aussparung 24 ist ein Führungselement vorgesehen, welches insbesondere die Form eines quer zur Richtung des Deckbandes 22 angeordneten, feststehenden Bügels 25 hat.

Das abgezogene Deckband 22 wird mittels einer von einem separaten Antriebsmotor 7 angetriebenen Antriebseinheit 6 transportiert (gezogen), die unterhalb des Bügels 25 am unteren Rand der Aussparung 24 angeordnet ist. Die Antriebseinheit 6 für das Deckband 22 liegt in der Bandebene, d.h., die Antriebsachse verläuft parallel zur Bandebene bzw. zur Grundplatte 2. Zum Einlegen des Deckbandes 22 kann an der Antriebseinheit 6 in an sich bekannter Weise ein aufklappbares Oberteil geöffnet und anschliessend wieder geschlossen werden.

Die Zuführeinheit 1 wird mittels eines Griffes 3 mit dem vorderen Abschnitt, in welchem das Transportrad 14 angeordnet ist, in eine entsprechende Aufnahme im Bestückungsautomaten eingesteckt. Zur Führung und Zentrierung dienen dabei ein oben liegender Führungsstift 26 und eine an der Unterseite angeordnete Führungsnase 28. Eine Verbindung mit dem Bestückungsautomaten zum Austausch elektrische Signale wird durch einen zwischen Führungsstift 26 und Führungsnase 28 plazierten mehrpoligen Steckkontakt 27 hergestellt. Diese Konfiguration ist im wesentlichen bereits aus der US-A-5,024,720 der Anmelderin bekannt.

Der Bandsensor 10 ist als optisch arbeitender Durchlichtsensor ausgebildet. Er besteht aus einer (optischen) Sendeeinheit 29, die mit LEDs oder dgl. ausgestattet ist, und einer der Sendeeinheit (optischen) Empfangseinheit 30, die mit entsprechenden lichtempfindlichen Elementen wie Photodioden oder dgl. ausgerüstet ist. Zwischen den beiden Einheiten 29, 30 wird das Band 23 so hindurchgeführt, dass sich bestimmte Markierungen am Band als Aenderungen in der Lichtübertragung zwischen Sendeeinheit 29 und Empfangseinheit 30 auswirken und in elektronische Signale umgewandelt werden, die zur weiteren Verarbeitung zur Verfügung stehen.

Eine wesentliche Aufgabe des Bandsensors 10 besteht darin innerhalb des Bandes 23 einen Spleiss zu detektieren. Ein solcher Spleiss tritt auf, wenn gemäss der vorliegenden Erfindung vor dem Ende eines von einer ersten Spule 21 in der Zuführeinheit 1 abgewickelten ersten Bandes bei laufenden Bestückungsvorgang das Bandende des ersten Bandes und der Bandanfang eines auf einer zweiten Spule aufgewickelten zweiten Bandes mittels eines Spleisses miteinander verbunden werden, in der Zuführeinheit 1 dann die erste Spule 21 gegen die zweite Spule ausgetauscht wird, und nach dem Auslaufen des ersten Bandes selbsttätig die in den Taschen des zweiten Bandes befindlichen Bauelemente von der Zuführeinheit 1 nacheinander zu der Entnahmestelle 13 transportiert werden. Hierbei wird der Spleiss zwangsweise am Bandsensor 10 vorbeigeführt, wo er detektiert werden kann.

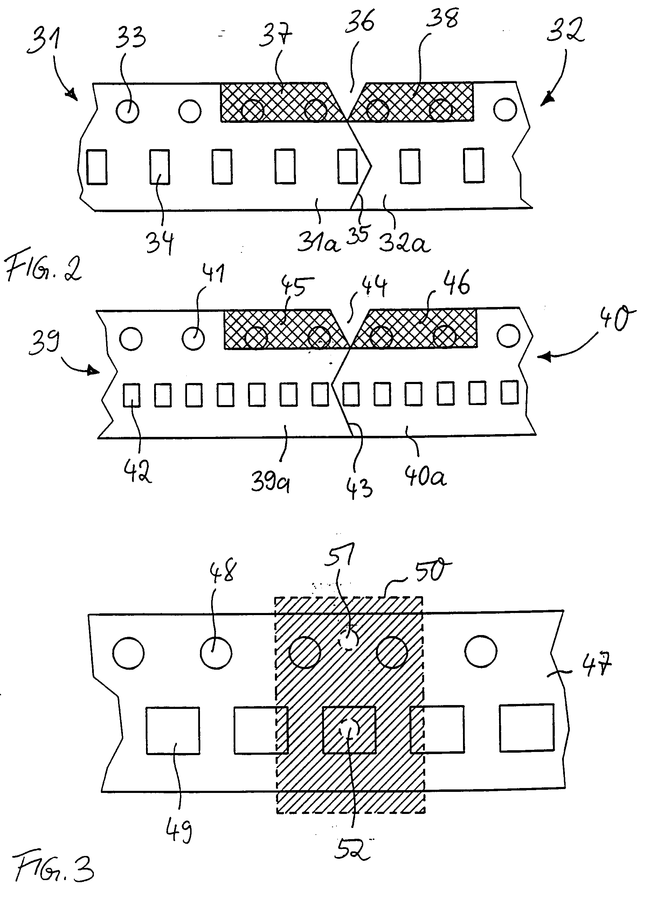

Bevorzugte Beispiele für einen Spleiss sind in Fig. 2 für zwei Paare von Bändern 31, 32 bzw. 39, 40 mit unterschiedlicher Schrittweite dargestellt. Die Bänder 31, 32 und 39, 40 enthalten jeweils eine fortlaufende Reihe von sich periodisch wiederholenden Taschen 34 bzw. 42 für die Bauelemente und Perforationen 33 bzw. 41 für den Bandtransport (mit dem Transportrad 14 in Fig. 1). Die Bandenden 32a bzw. 40a der ersten Bänder 32 bzw. 40 und die Bandanfänge 31a bzw. 39a der zweiten Bänder 31 bzw. 39 werden in einer (nicht gezeigten) Spleissapparatur so zurechtgeschnitten und miteinander verbunden (verklebt), dass sich die in Fig. 2 gezeigten Spleisse 35 bzw. 43 ergeben. Für die Detektion der Spleisse 35, 43 wichtig sind die keilförmigen Aussparungen 36 bzw. 44 der Spleisse 35 bzw. 43 im Bereich der Perforationen 33 bzw. 41. Diese Aussparungen 36, 44 dienen als Markierungen, die das Vorhandensein des Spleisses anzeigen und vom Bandsensor 10 detektiert werden. Die Aussparungen 36, 44 sind vorzugsweise exakt in der Mitte der durch die Perforationen 33, 41 vorgegebenen (4mm-)Teilung positioniert, damit das darauf basierende Detektionssignal des Bandsensors 10 direkt mit dem Taktsignal für das Transportrad 14 verknüpft werden kann.

Da die Bänder 31, 32 bzw. 39, 40 in der Regel aus einem durchsichtigen Kunststoff bestehen, führen die Aussparungen 36, 44 für sich genommen nur zu einer geringen Aenderung in der Lichtdurchlässigkeit. Um daher klare und eindeutige Detektionssignale zu erhalten, werden vorzugsweise vor und/oder nach der Aussparung 36 bzw. 44 auf dem gespleissten Band optisch undurchlässige Abdeckbereiche 37, 38 bzw. 45, 46 vorgesehen, die in Fig. 2 durch eine Kreuzschraffur kenntlich gemacht sind. Wird der vollen Lichtdurchlässigkeit eine logische "1" zugeordnet, und der Lichtundurchlässigkeit eine logische "0", ergibt sich bei der in Fig. 2 gezeigten Konfiguration der Abdeckbereiche 37, 38 bzw. 45, 46 und Aussparungen 36 bzw. 44 am Bandsensor 10 bei einer Schrittweite, die dem halben Abstand der Perforationen 33, 41 (nämlich 2mm) entspricht, jeweils eine Signalfolge "0001000", die leicht und eindeutig vom Bandsensor 10 als Spleiss-Signal diskriminiert werden kann.

Der Bandsensor 10 ist gemäss Fig. 3 vorzugsweise als kombinierter Sensor ausgebildet. Dies bedeutet, dass er bei einem Band 47 mit Perforationen 48 und Taschen 49 nicht nur die Aussparung (36, 44 in Fig. 2) detektieren kann, welche das Vorhandensein eines Spleisses anzeigt, sondern auch ein bestimmte codierte Folge von leeren und vollen Taschen, die als Markierung zur Trennung von bestimmten Abschnitten auf einem Band dient. Solche Bandabschnitte werden insbesondere eingeteilt, um Bauelemente, die in demselben Batch hergestellt worden sind und in ihren Bauelementeigenschaften daher besonders gut zueinander passen, für die Bestückung zusammenzufassen (siehe dazu die US-A-4,610,083) und von Bauelementen aus einem anderen Batch abzugrenzen. Im kombinierten Bandsensor 10 sind gemäss Fig. 4 nebeneinander quer zur Bandrichtung ein Spleiss-Sensor 53 und ein Leertaschen-Sensor 54 angeordnet. Die optische Trennung der Strahlengänge beider Sensoren erfolgt gemäss Fig. 3 durch eine Blende 50, die im Bereich der Perforation 48 eine erste Blendenöffnung 51, und im Bereich der Taschen 49 eine zweite Blendenöffnung 52 aufweist. Die erste Blendenöffnung 51 ist so angeordnet, dass durch sie optimal die Aussparungen (36, 44) eines Spleisses (35, 43) detektiert werden können. Die zweite Blendenöffnung 52 ist so angeordnet, dass durch sie optimal detektiert werden kann, ob eine Tasche 49 leer (d.h. lichtdurchlässig) ist, oder ob sie ein Bauelement enthält (d.h. lichtundurchlassig ist).

Das Zusammenwirken der Zuführeinheit 1 mit dem Bestückungsautomaten 55 im Hinblick auf die Detektion eines Spleisses bzw. von Abschnitten eines Bandes lässt sich an dem in Fig. 4 dargestellten Blockschaltbild erläutern. Die Zuführeinheit 1 ist am Bestückungsautomaten 55 eingesteckt. Dadurch wird über den Steckkontakt 27 (siehe auch Fig. 1) eine Verbindung für den Datenaustausch zwischen der (lokalen) Steuereinheit 8 der Zuführeinheit 1 und der Zentraleinheit 56 des Bestückungsautomaten 55 hergestellt. Der Spleiss-Sensor 53 und der Leertaschen-Sensor 54 sind an die Steuereinheit 8 angeschlossen; es ist aber auch denkbar, dass die beiden Sensoren 53, 54 über den Steckkontakt 27 direkt mit der Zentraleinheit 56 verbunden sind. Weiterhin ist im Bestückungsautomaten 55 der Zentraleinheit 56 ein Datenspeicher 57 zugeordnet, in den (entweder - wie gezeigt - direkt, oder über die Zentraleinheit 56) mittels einer Eingabeeinheit 58 charakteristische Daten eines in der Zuführeinheit 1 zu verarbeitenden Bandes samt den darin befindlichen Bauelementen eingegeben und eingespeichert werden können. Sind die charakteristischen Daten beispielsweise in Form eines Barcode-Streifens auf der Spule angebracht, kann die Eingabeeinheit als Barcodeleser ausgebildet sein. Aber auch andere Methoden mit Magnetstreifen, einer Tastatur oder dgl. sind denkbar.

Wird in der Zuführeinheit 1 gerade ein erstes Band mit Bauelementen verarbeitet, sind die charakteristischen Daten des Bandes in der Zentraleinheit 56 abgelegt. Die Steuereinheit 8 steuert in der Zuführeinheit 1 gemäss den Befehlen aus der Zentraleinheit 56 den Antriebsmotor 15 für das Band, so dass das Band schrittweise an der Entnahmestelle 13 vorbeitransportiert wird und die Entnahmevorrichtung an der Entnahmestelle bei Bedarf ein Bauelement aus einer Tasche des Bandes entnehmen und der Bestückung zuführen kann. Wird nun (z.B. aufgrund einer codierten Leertaschenfolge, die vom Leertaschen-Sensor 54 detektiert wird) das baldige Ende des Bandes angezeigt, erscheint am Bestückungsautomaten eine Nachricht an das Bedienpersonal, dass sich das Band in dieser bestimmten Zuführeinheit dem Ende zuneigt. Das Bedienpersonal nimmt dann bei eingesteckter Zuführeinheit die erste Spule mit dem ersten Band aus der Spulenaufnahme 19 (Fig. 1), löst das Bandende des ersten Bandes von der ersten Spule, und spleisst den Bandanfang eines zweiten Bandes, dass sich auf einer zweiten Spule befindet, mit dem Bandende des ersten Bandes zusammen. Anschliessend werden mittels der Eingabeeinheit die charakteristischen Daten (Bandlänge, Bandbreite, Pitch, Bauelement-Typ etc.) von der zweiten Spule ab- und in den Datenspeicher 57 eingelesen. Die zweite Spule kann dann in die Spulenaufnahme der Zuführeinheit 1 eingesetzt werden. Dies alles geschieht, ohne das der gerade laufende Bestückungsvorgang unterbrochen werden muss.

Wird nun im weiteren Verlauf der Verarbeitung des ersten Bandes vom Spleiss-Sensor 53 im Bandsensor 10 der Spleiss mit dem zweiten Band detektiert, wird der Inhalt des Datenspeichers 57 von der Zentraleinheit 56 ausgelesen und anschliessend mit den dort vorhandenen charakteristischen Daten des ersten Bandes verglichen. Stimmen die Daten in einer vorgegebenen Weise überein, die sicherstellt, dass das richtige Nachfolgeband ausgewählt und angespleisst worden ist, werden die Daten aus dem Datenspeicher 57 zur Verwendung freigegeben und die Verarbeitung des zweiten Bandes beginnt. Ergibt sich eine fehlende Uebereinstimmung, wird dies als Warnung dem Bedienpersonal angezeigt und die Weiterverarbeitung des zweiten Bandes unterbleibt. Auf diese Weise kann bei gleichzeitig hoher Bediensicherheit und ohne Leistungsverlust der Nachschub an Bauelementen sichergestellt werden.

Der Einsatz des Leertaschen-Sensors 54 im Bandsensor 10 geht davon aus, dass gemäss Fig. 5 jedes Band 59 in einzelne, aufeinanderfolgende Bandabschnitte 59a, 59b unterteilt ist, wobei in jedem der Bandabschnitte 59a, 59b jeweils Bauelemente vom selben Typ und aus demselben Batch untergebracht sind. Zwischen aufeinanderfolgenden Bandabschnitten 59a, 59b ist jeweils eine Markierung 63 vorgesehen, die vorzugsweise aus einer codierten Abfolge von Leertaschen 64 und gefüllten Taschen 60 besteht. Beim Durchlaufen des Bandes 59 in der Zuführeinheit 1 werden die Markierungen 63 zwischen den Bandabschnitten 59a, 59b vom dem Leertaschen-Sensor 54 detektiert.

Bei der Verwendung von in Bandabschnitte unterteilten Bändern wird meist eine vom Bestückungsautomaten 55 zu bestückende Schaltung jeweils mit mehreren aus demselben Batch stammenden Bauelementen bestückt. Bei Detektion eines Bandabschnitt-Wechsels (z.B. von 59a nach 59b) prüft nun der Bestückungsautomat 55 bzw. dessen Zentraleinheit 56 selbsttätig, ob im gerade verwendeten Bandabschnitt noch eine ausreichende Anzahl von Bauelementen eines Batches vorhanden ist, um eine bestimmte Anzahl von weiteren Schaltungen zu bestücken. Wenn dies nicht der Fall ist, weist der Bestückungsautomat 55 die Zuführeinheit 1 an, sofort zum Anfang des neuen Bandabschnitts vorzurücken. Wenn dies dagegen der Fall ist, weist der Bestückungsautomat 55 die Zuführeinheit 1 an, nach Bestückung der bestimmten Anzahl von weiteren Schaltungen zum Anfang des neuen Bandabschnitts vorzurücken. Für den Fall, dass am Ende des gerade verwendeten Bandabschnitts ein Spleiss detektiert wird, weist der Bestückungsautomat 55 die Zuführeinheit 1 an, zum Beginn des nächsten Bandes vorzurücken.

Damit das schrittweise Vorrücken des Bandes 59 in der Zuführeinheit sicher und genau zum neuen Bandabschnitt bzw. zum Anfang des angespleissten nächsten Bandes führt, ist es zweckmässig und vorteilhaft, den Abstand A zwischen der Position des Bandsensors 10 bzw. des Spleiss-Sensors 53 und des Leertaschen-Sensors 54 sowie der Position der Entnahmevorrichtung 62 (beide sind in Fig. 5 schematisch eingezeichnet) als ein ganzzahliges Vielfaches der einfachen Schrittweite (2mm), z.B. 120mm oder 148mm, zu wählen. Die einfache Schrittweite entspricht dabei dem halben Anstand der Perforation 61. Der Bestückungsautomat bzw. die Zuführeinheit weiss dann genau, nach wieviel Schritten beim Vorrücken des Bandes der nächste Bandabschnitt bzw. das nächste band zur Bauelement-Entnahme zur Verfügung steht.

Insgesamt ergeben sich mit der Erfindung die folgenden wesentlichen Merkmale und Vorteile:
- Der Spleiss-Sensor ermöglicht eine automatische und synchrone Uebernahme der relevanten Daten (insbes. Bauelemente-Menge) des neu angekoppelten Bandes.
- Der Leertaschen-Sensor ermöglicht eine automatische Steuerung der Zuführeinheit und des Bestückungsautomaten unter Auswertung einer Leertaschen-Codierung. Die Leertaschen-Codierung zeigt ein Batch-Ende bzw. einen Batch-Anfang auf dem Band an.
- Der Spleiss-Prozess kann asynchron und während des Bestückungsprozesses erfolgen.
- Bestückungsfehler werden sicher verhindert, weil die Spleissung kontrolliert mittels Barcode erfolgt: Freigabe für das angekoppelte Band erfolgt nur bei Uebereinstimmung der Dateninhalte der beiden Barcodes (altes/neues Band).
- Kontrollierte und synchrone Uebernahme der relevanten Daten des angekoppelten Bandes wie: Bandbreite, Pitch, Bauelemente-Identifikation/ -abmessungen/ -Werte/ -Menge, Prozessdaten etc.
- Dem Bestückungsautomaten wird eine programmierbare Anzahl Bauelemente pro Schaltung, welche garantiert aus demselben Batch stammt, zur Bestückung auf einer Schaltung bereitgestellt.
- Es gibt keinen Bestückungs-Leistungsverlust: Die Zuführeinheit wird automatisch gesteuert, d.h. eine ungenügende Bauteile-Menge am Batch-Ende wird verworfen und die Zuführeinheit transportiert automatisch zum nächsten Batchanfang.

### BEZEICHNUNGSLISTE

- 1: Zuführeinheit (Feeder)
- 2: Grundplatte
- 3: Griff
- 4: Führungselement (Band)
- 5: Umlenkwelle
- 6: Antriebseinheit (Deckband)
- 7: Antriebsmotor (Deckband)
- 8: Steuereinheit (elektronisch)
- 9: Umlenkrolle
- 10: Bandsensor
- 11,16,17: Führungskanal
- 12: Abziehvorrichtung (Deckband)
- 13: Entnahmestelle
- 14: Transportrad (Band)
- 15: Antriebsmotor (Band)
- 18: Führungselement (Trägerband)
- 19: Spulenaufnahme
- 20: Laufrolle
- 21: Spule
- 21a: Achse (Spule)
- 22: Deckband
- 23: Band
- 24: Aussparung
- 25: Bügel
- 26: Führungsstift
- 27: Steckkontakt
- 28: Führungsnase
- 29: Sendeeinheit
- 30: Empfangseinheit
- 31,32: Band
- 31a,39a: Bandanfang
- 32a,40a: Bandende
- 33,41,48: Perforation
- 34,42,49: Tasche
- 35,43: Spleiss
- 36,44: Aussparung
- 37,38: Abdeckbereich
- 39,40,47: Band
- 45,46: Abdeckbereich
- 50: Blende
- 51: Blendenöffnung (Spleiss-Sensor)
- 52: Blendenöffnung (Leertaschen-Sensor)
- 53: Spleiss-Sensor
- 54: Leertaschen-Sensor
- 55: Bestückungsautomat
- 56: Zentraleinheit
- 57: Datenspeicher
- 58: Eingabeeinheit
- 59: Band
- 59a,b: Bandabschnitt
- 60: Tasche
- 61: Perforation
- 62: Entnahmevorrichtung (Pick-up)
- 63: Markierung
- 64: Leertasche
- A: Abstand

## Patentansprüche

1. Verfahren zur Zuführung von Bauelementen, die in einem mit einer periodischen Abfolge von einzelnen Taschen (34, 42, 49, 60) versehenen Band (23, 31, 33, 39, 40, 47) untergebracht sind, mittels einer Zuführeinheit (1) zu einem Bestückungsautomaten (55), bei welchem Verfahren das auf einer Spule (21) aufgewickelte Band (23, 31, 33, 39, 40, 47) in der Zuführeinheit (1) von der Spule (21) abgewickelt und die in den Taschen (34, 42, 49, 60) befindlichen Bauelemente nacheinander zu einer Entnahmestelle (13) transportiert werden, wo sie von dem Bestückungsautomaten (55) aus der jeweiligen Tasche des Bandes entnommen werden können, dadurch gekennzeichnet, dass vor dem Ende eines von einer ersten Spule in der Zuführeinheit (1) abgewickelten ersten Bandes (32, 40) bei laufendem Bestückungsvorgang das Bandende (32a, 40a) des ersten Bandes (32, 40) und der Bandanfang (31a, 39a) eines auf einer zweiten Spule aufgewickelten zweiten Bandes (31, 39) mittels eines Spleisses (35, 43) miteinander verbunden werden, dass in der Zuführeinheit (1) die erste Spule gegen die zweite Spule ausgetauscht wird, und dass nach dem Auslaufen des ersten Bandes (32, 40) selbsttätig die in den Taschen des zweiten Bandes (31, 39) befindlichen Bauelemente von der Zuführeinheit (1) nacheinander zu der Entnahmestelle (13) transportiert werden.

2. Verfahren nach Anspruch 1, dadurch gekennzeichnet, dass in der Zuführeinheit (1) der Durchlauf des Spleisses (35, 43) vor der Entnahmestelle (13) detektiert wird, und dass auf die Detektion des Spleisses (35, 43) hin charakteristische Daten des zweiten Bandes (31, 39) und der darin enthaltenen Bauelemente selbsttätig für die Steuerung des Bestückungsautomaten (55) bereitgestellt werden.

3. Verfahren nach Anspruch 2, dadurch gekennzeichnet, dass im Zusammenhang mit dem Spleissen des ersten und zweiten Bandes (32, 40 bzw. 31, 39) die charakteristischen Daten des zweiten Bandes (31, 39) bzw. der darin enthaltenen Bauelemente zunächst in einen Datenspeicher (57) eingelesen werden, und dass die Daten nach der Detektion des Spleisses (35, 43) aus dem Datenspeicher (57) ausgelesen und an eine Zentraleinheit (56) zur Steuerung des Bestückungsautomaten (55) weitergegeben werden.

4. Verfahren nach Anspruch 3, dadurch gekennzeichnet, dass nach dem Einlesen der charakteristischen Daten des zweiten Bandes (31, 39) die charakteristischen Daten der beiden Bänder (32, 40 bzw. 31, 39) und der Bauelemente in beiden Bändern (32, 40 bzw. 31, 39) im Bestückungsautomaten (55) zunächst selbsttätig miteinander verglichen werden, und der Bestückungsprozess mit Bauelementen des zweiten Bandes (31, 39) nur dann weitergeführt wird, wenn zwischen den verglichenen charakteristischen Daten eine vorgegebene Uebereinstimmung festgestellt wird.

5. Verfahren nach einem der Ansprüche 2 bis 4, dadurch gekennzeichnet, dass zur Anzeige des Spleisses (35, 43) an den gespleissten Bändern Markierungen vorgesehen sind, und dass zur Detektion des Spleisses (35, 43) die Markierungen detektiert werden.

6. Verfahren nach Anspruch 5, dadurch gekennzeichnet, dass als Markierungen optische Markierungen verwendet werden, welche optisch detektiert werden.

7. Verfahren nach Anspruch 6, dadurch gekennzeichnet, dass als optische Markierung eine Aussparung (36, 44) verwendet wird, und dass die Aussparung (36, 44) direkt am Spleiss (35, 43) angeordnet ist.

8. Verfahren nach Anspruch 7, dadurch gekennzeichnet, dass zur Erhöhung der Detektionssicherheit vor und/oder nach der Aussparung (36 bzw. 44) auf dem gespleissten Band optisch undurchlässige Abdeckbereiche (37, 38 bzw. 45, 46) vorgesehen werden.

9. Verfahren nach einem der Ansprüche 2 bis 8, dadurch gekennzeichnet, dass jedes Band (59) in einzelne, aufeinanderfolgende Bandabschnitte (59a,b) unterteilt ist, wobei in jedem der Bandabschnitte (59a,b) jeweils Bauelemente vom selben Typ und aus demselben Batch untergebracht sind, dass zwischen aufeinanderfolgenden Bandabschnitten (59a,b) jeweils eine Markierung (63) vorgesehen ist, dass beim Durchlaufen des Bandes in der Zuführeinheit (1) die Markierungen (63) zwischen den Bandabschnitten (59a,b) detektiert werden, und dass die Detektion der Bandabschnitte (59a,b) zusammen mit der Detektion des Spleisses (35, 43) zur Steuerung der Zuführeinheit (1) verwendet wird.

10. Verfahren nach Anspruch 9, dadurch gekennzeichnet, dass eine vom Bestückungsautomaten (55) zu bestückende Schaltung jeweils mit mehreren aus demselben Batch stammenden Bauelementen bestückt wird, dass bei Detektion eines Bandabschnitt-Wechsels der Bestückungsautomat (55) selbsttätig prüft, ob im gerade verwendeten Bandabschnitt noch eine ausreichende Anzahl von Bauelementen eines Batches vorhanden ist, um eine bestimmte Anzahl von weiteren Schaltungen zu bestücken, dass, wenn dies nicht der Fall ist, der Bestückungsautomat (55) die Zuführeinheit (1) anweist, sofort zum Anfang des neuen Bandabschnitts vorzurücken, und dass, wenn dies der Fall ist, der Bestückungsautomat (55) die Zuführeinheit (1) anweist, nach Bestückung der bestimmten Anzahl von weiteren Schaltungen zum Anfang des neuen Bandabschnitts vorzurücken.

11. Verfahren nach Anspruch 10, dadurch gekennzeichnet, dass, wenn am Ende des gerade verwendeten Bandabschnitts ein Spleiss detektiert wird, der Bestückungsautomat (55) die Zuführeinheit (1) anweist, zum Beginn des nächsten Bandes vorzurücken.

12. Zuführeinheit (1) zur Durchführung des Verfahren nach einem der Ansprüche 2 bis 11, in welcher Zuführeinheit (1) das mit den Bauelementen gefüllte Band (23, 31, 33, 39, 40, 47) mittels eines durch eine Steuereinheit (8) gesteuerten Antriebs (14, 15) schrittweise an einer Entnahmestelle (13) vorbeibewegt wird, wobei die Steuereinheit (8) über Verbindungsmittel (27) mit einer Zentraleinheit (56) des Bestückungsautomaten (55) Daten austauscht, dadurch gekennzeichnet, dass in Laufrichtung des Bandes (23, 31, 33, 39, 40, 47) vor der Entnahmestelle (13) ein Spleiss-Sensor (53) für die Detektion eines Spleisses (35, 43) angeordnet ist.

13. Zuführeinheit nach Anspruch 12, dadurch gekennzeichnet, dass der Spleiss-Sensor (53) an die Steuereinheit (8) der Zuführeinheit (1) angeschlossen ist.

14. Zuführeinheit nach einem der Ansprüche 12 und 13, dadurch gekennzeichnet, dass zusätzlich zu dem Spleiss-Sensor (53) ein Bandabschnitts-Sensor zur Detektion von Bandabschnitten vorgesehen ist, und dass als Bandabschnitts-Sensor ein Leertaschen-Sensor (54) zur Detektion von Leertaschen (64) verwendet wird.

15. Zuführeinheit nach einem der Ansprüche 12 bis 14, dadurch gekennzeichnet, dass der Spleiss-Sensor (53) und der Leertaschen-Sensor (54) als optische Sensoren ausgebildet sind, und dass die beiden Sensoren (53, 54) als Durchlichtsensoren ausgebildet sind.

16. Zuführeinheit nach Anspruch 15, dadurch gekennzeichnet, dass der Spleiss-Sensor (53) und der Leertaschen-Sensor (54) in einem Bandsensor (10) zusammengefasst sind, und dass die beiden Sensoren (53, 54) im Bandsensor (10) quer zur Bandlaufrichtung nebeneinander angeordnet sind, wobei der Leertaschen-Sensor (54) das Band (23, 31, 33, 39, 40, 47) im Bereich der Taschen (34, 42, 49, 60) abtastet, und der Spleiss-Sensor (53) das Band (23, 31, 33, 39, 40, 47) im Bereich der Perforation (33, 41, 48, 61) abtastet.

17. Zuführeinheit nach einem der Ansprüche 12 bis 16, dadurch gekennzeichnet, dass der Bandsensor (10) in einem vorbestimmten Abstand zur Entnahmestelle (13) angeordnet ist, und dass der vorbestimmte Abstand ein ganzzahliges Vielfaches der Schrittweite (P) des Bandes (23, 31, 33, 39, 40, 47) beträgt.

18. Bestückungsautomat (55) zur Durchführung des Verfahrens nach einem der Ansprüche 3 bis 11, umfassend eine Zentraleinheit (56) zur Steuerung des Bestückungsvorgangs, dadurch gekennzeichnet, dass ein Datenspeicher (57) zur Speicherung der charakteristischen Daten eines neuen Bandes vorgesehen ist, und dass der Datenspeicher (57) mit der Zentraleinheit (56) verbunden ist.

19. Bestückungsautomat nach Anspruch 18, dadurch gekennzeichnet, dass an den Bestückungsautomaten (55) eine Eingabeeinheit (58) anschliessbar ist, welche mit dem Datenspeicher (57) in Verbindung steht.

20. Bestückungsautomat nach Anspruch 19, dadurch gekennzeichnet, dass die Eingabeeinheit als Strichcode-Leseeinheit ausgebildet ist.
